# EUROPÄISCHE PATENTSCHRIFT

(11) **EP 2 162 571 B1**
(45) Veröffentlichungstag und Bekanntmachung des Hinweises auf die Patenterteilung: **21.12.2011**
(21) Anmeldenummer: 08784553.3
(22) Anmeldetag: 17.06.2008
(51) Int. Cl.: C30B 15/30, C30B 11/00

(54) **VORRICHTUNG UND VERFAHREN ZUR HERSTELLUNG VON KRISTALLEN AUS ELEKTRISCH LEITENDEN SCHMELZEN**
DEVICE AND METHOD FOR PRODUCING CRYSTALS FROM ELECTROCONDUCTIVE MELTS
DISPOSITIF ET PROCÉDÉ DE PRODUCTION DE CRISTAUX À PARTIR DE BAINS FONDUS ÉLECTRIQUEMENT CONDUCTEURS

(30) Priorität: 18.06.2007 DE 102007028548
(43) Veröffentlichungstag der Anmeldung: 17.03.2010
(73) Patentinhaber: Forschungsverbund Berlin E.V., 12489 Berlin (DE)
(72) Erfinder: LANGE, Ralph-Peter, 10318 Berlin (DE); RUDOLPH, Peter, 12529 Schönefeld (DE); KLEIN, Olaf, 13125 Berlin (DE); FRANK-ROTSCH, Christiane, 16727 Oberkrämer (DE); NACKE, Bernard, 31303 Burgdorf (DE)
(74) Vertreter: Gulde Hengelhaupt Ziebig & Schneider
(86) Internationale Anmeldenummer: PCT/EP2008/005190
(87) Internationale Veröffentlichungsnummer: WO 2008/155137

(56) Entgegenhaltungen:
- DE-A1- 10 349 339
- DE-A1- 19 652 543
- US-A1- 2002 092 461
- GIESS E A ET AL: "COMBINATION HEATER-MAGNETIC SOLENOID COIL(S) FOR SUPPRESSING MELT CONVECTION IN CRYSTAL GROWTH" IBM TECHNICAL DISCLOSURE BULLETIN, IBM CORP. NEW YORK, US, Bd. 26, Nr. 9, 1. Februar 1984 (1984-02-01), Seite 4716, XP002054780 ISSN: 0018-8689

## Beschreibung

Die Erfindung betrifft eine Vorrichtung und ein Verfahren zur Herstellung von Kristallen aus elektrisch leitenden Schmelzen.

Bei der Züchtung von Kristallen aus der Schmelze ist die Schmelzströmung von entscheidender Bedeutung. Sie beeinflusst zum einen die Form der Phasengrenze zwischen Kristall und Schmelze und zum anderen das zeitliche Verhalten der Temperatur in der Schmelze, die Temperaturoszillation, und die Dotierstoffverteilungen. Die auftretenden Strömungen in der Schmelze sind dabei örtlich inhomogen verteilt. Das Strömungsfeld in der Schmelze wird durch die thermische Auftriebskonvektion, Maragonikonvektion sowie durch die Kristall- und Tiegelrotation bedingt.

Als ein zentrales wissenschaftlich-technisches Problem, das es zu lösen gilt, ist die Eindämmung der mit wachsendem Schmelzvolumen stark zunehmender Auftriebskonvektion, deren Instationarität sich negativ auf die strukturellen und physikalischen Eigenschaften der wachsenden Kristalle auswirkt [vgl. D. T. J. Hurle, Handbook of Crystal Growth, Vol. 2a-b, Elsevier, North-Holland 1994].

Die Kontrolle der Schmelzkonvektion ermöglicht Temperaturfluktuationen in der Schmelze zu reduzieren und die Form der Phasengrenze zu optimieren.

Bisher wird die Schmelzkonvektion insbesondere durch die Wahl der Rotationsraten von Tiegel und Kristall beeinflusst. Als eine weitere wirksame technische Gegenmaßnahme haben sich die Anwendung magnetischer Felder erwiesen [G. Müller in: Theoretical and Technological Aspects of Crystal Growth, Ed. R. Fornari and C. Paorici, Trans. Tech. Publ., Zuerich 1998, p. 87]. Über die Erzeugung von Lorentzkräften können Strömungsanteile in elektrisch leitenden Schmelzen gedämpft oder verstärkt werden. Es sind verschiedene Vorgehensweisen bekannt, um den Wärme- und Stofftransport in der Schmelze zu beeinflussen. In US2002/0092461 A1 wird eine Vorrichtung zur Kristallzüchtung beschrieben, bei der die Magnetfelder in außerhalb der Züchtungsanlage angebrachten Spulen erzeugt werden.

Bekannt sind des weiteren Heizeranordnungen, die gleichzeitig Wärme und ein longitudinales magnetisches Wanderfeld erzeugen. So wird in DE 10102126 A 1 auf eine rotationssymmetrische Heizeranordnung verwiesen, die simultan als spiralförmiger Mehrphaseninduktor ausgebildet ist.

In DE 103 49 339 A1 wird vorgeschlagen, innerhalb der Züchtungskammer eine Heizeinrichtung in Form von übereinander angeordneten Spulen zu verwenden. Die dort beschriebene Heizeinrichtung dient einerseits der Erzeugung eines für die Kristallzüchtung erforderlichen Temperaturfeldes und zugleich der Erzeugung von wandernden Magnetfeldern. Die als Mehrspulenanordnung aufgebaute Heizeinrichtung umschließt den Tiegel und die darin enthaltene Schmelze zylinderförmig. Die in DE 103 49 339 A1 beschriebene Spulenanordnung weist drei Spulensegmente auf, die an eine Drei-Phasen-Wechselstromquelle angeschlossen werden. Durch die Spulen fließt jeweils ein phasenverschobener Strom, wodurch ein auf- oder abwärts wanderndes Magnetfeld erzeugt wird. Dieses induziert in die Schmelze elektrische Ströme, die auf Grund des vorhandenen Magnetfeldes Lorentzkräfte in der elektrisch leitenden Schmelze hervorrufen. Durch diese soll die Konvektion in der Schmelze beeinflusst werden.

Nachteilig an der Vorrichtung in DE 103 49 339 A1 ist jedoch, dass sich in der Schmelze ein Kraftfeld entsprechend der zylindrischen Form der Heizeinrichtung mit konstantem Querschnitt und konstantem Durchmesser einstellt. In diesem Fall befindet sich die maximal erzeugte Lorentzkraftdichte stets im radialen Randbereich des Tiegels und nimmt zum Tiegelinneren ab . Die Position des Maximums des Kraftfeldes wird durch die Position des Tiegels in der Kristallzüchtungsanlage bestimmt. Es hat sich jedoch gezeigt, dass sich u. a. bei der Züchtung nach dem Czochralski-Verfahren störende Auftriebsströmungen unter dem Kristall ausbilden, die sog. Proudman-Taylor-Instabilitäten. Diese Auftriebsströmungen können mit der oben beschriebenen Vorrichtung nicht beeinflusst werden. Weiterhin erlaubt ein gleichförmiger zylindrischer Spulenaufbau, d. h. eine Heizeinrichtung deren Spulen einen konstanten Durchmesser aufweisen, sowie eine gleichmäßige Stromeinspeisung keine Variation der Form der wandernden Magnetfelder und der davon erzeugten Lorentzkraftfelder.

In einer Veröffentlichung von Thomas Wetzel "Die Schmelzströmung im Si-Czochralski-Prozess unter dem Einfluss elektromagnetischer Felder", in: Fortschritt-Berichte VDI, Reihe 9, Nr. 328, wird vorgeschlagen, unter dem Tiegelboden eine wechselstromdurchflutete Spule ("Bodeninduktor") zur Beeinflussung der Schmelzkonvektion anzubringen.

Nachteilig hierbei ist, dass der Bodeninduktor nicht an die anderen Heizelemente gekoppelt ist.

Aufgabe der Erfindung ist es, eine Vorrichtung und ein Verfahren zur Herstellung von Kristallen aus elektrisch leitenden Schmelzen bereitzustellen, bei der Temperaturfluktuationen in der Schmelze deutlich reduziert und die Kristallqualität verbessert wird. Weiterhin ist es Aufgabe der Erfindung, den Stoff- und Wärmetransport in der Schmelze zu verbessern.

Die Aufgabe wird gelöst mit einer Vorrichtung und einem Verfahren gemäß den Merkmalen des Anspruches 1 und des Anspruches 14.

Vorteilhafte Ausgestaltungen sind in den Unteransprüchen enthalten.

So ist die Vorrichtung zur Herstellung von Kristallen aus elektrisch leitenden Schmelzen, mindestens aufweisend einen in einer Züchtungskammer angeordneten, eine Schmelze enthaltenen Tiegel mit einem Tiegelboden, eine den Tiegel umgebende Heizeinrichtung, welche als Mehrspulenanordnung von über einander angeordneten Spulen ausgeführt ist und zur gleichzeitigen Erzeugung eines magnetischen Wanderfeldes dient, wobei die Spulen elektrisch mit mindestens einer außerhalb der Züchtungskammer angeordneten Energieversorgungseinrichtung über durch die Züchtungskammer geführte Spulenanschlüsse elektrisch verbunden sind, dadurch gekennzeichnet, dass Windungen der Mehrspulenanordnung einen Abstand von einer gedachten Tiegelmittelachse zum Innenrand der Windungen aufweisen, der mindestens bei einer Windung verschieden von den übrigen Windungen bei gleichem oder verschiedenen Windungsquerschnitten ist.

Das erfindungsgemäße Verfahren zur Herstellung von Kristallen aus elektrisch leitenden Schmelzen mittels einer Vorrichtung nach mindestens einem der Ansprüche 1 bis 13, wobei in einer in einem Tiegel enthaltene Schmelze durch eine aus Spulen aufgebaute Mehrspulenanordnung ein Lorentzkraftfeld mit einem im Bereich einer Tiegelwand aufweisenden Lorentzkraftdichtemaximum erzeugt wird, ist dadurch gekennzeichnet, dass das Lorentzkraftdichtemaximum vom Bereich der Tiegelwand durch Steuerung der in die Spulen eingespeisten Größen Stromstärke, Phasenverschiebung und Frequenz zu einer gedachten Tiegelmittelache hin verschoben wird.

Die erfindungsgemäße Mehrspulenanordnung nimmt eine von der üblichen geraden zylindrischen Form abweichende Form an, wobei die Form der Heizeinrichtung insbesondere eine "tulpenförmige" Ausgestaltung annehmen kann.

Durch eine von der Zylinderform abweichenden Spulenanordnung bei der erfindungsgemäßen Vorrichtung kann das erzeugte Lorentzkraftfeld örtlich in der Schmelze positioniert werden. Auf diese Weise wird die Beeinflussung der Strömung von den Randbereichen in das Innere des Tiegels ausgeweitet. Die Verteilung des magnetischen Kraftfeldes in der Schmelze wird mit der erfindungsgemäßen Vorrichtung nicht nur von der Position des Tiegels innerhalb der Heizeinrichtung bestimmt.

Mit der erfindungsgemäßen Vorrichtung können Bereiche der Heizeinrichtung miteinander verkoppelt und als kombinierte Heizer-Magnetfeldanordnung ausgeführt werden.

Die erfindungsgemäße Vorrichtung kann in denjenigen Kristallzüchtungsanlagen eingesetzt werden, die nach dem Czochralski-Verfahren, der vertikalen Bridgman- bzw. Gradient-Freeze-Methode, aber auch nach dem Kyropolus- und Heat-Exchanger-Verfahren arbeiten. Weiterhin ist diese Vorrichtung - neben der Züchtung von Einkristallen - auch zur Herstellung von polykristallinem Halbleitermaterial geeignet.

Bei der erfindungsgemäßen Vorrichtung weicht der Abstand mindestens einer Windung von einer gedachten Tiegelmittelachse zum Innenrand der Windung gegenüber dem Abstand bzw. den Abständen der anderen Windungen der Mehrspulenanordnung ab.

Es ist erfindungsgemäß vorgesehen, dass, falls der Abstand zur gedachten Tiegelmittelachse bei allen Windungen gleich ist, bei mindestens einer Windung der Windungsquerschnitt verschieden von den übrigen Windungen ist.

Betrachtet man eine Windung in Blickrichtung der gedachten Tiegelmittelachse, so erkennt man die von der Windung umschlossene Fläche, die üblicherweise einen Kreis bildet, durch dessen Mittelpunkt die gedachte Tiegelmittelachse läuft. In einer erfindungsgemäßen Spulenanordnung kann diese Fläche die Form einer beliebigen geometrischen Fläche aufweisen, insbesondere können auch Ellipsen, Quadrate, Dreiecke, Rechtecke oder andere n-Ecke als umschlossene Fläche auftreten.

Eine bevorzugte Ausführungsform der erfindungsgemäßen Vorrichtung ist dadurch gekennzeichnet, dass mindestens eine weitere Spule unterhalb des Tiegelbodens des Tiegels angeordnet ist.

In einer nächsten bevorzugten Ausführungsform der erfindungsgemäßen Vorrichtung ist vorgesehen, dass die unterhalb des Tiegelbodens angeordneten Spulen Windungen aufweisen, die ineinander angeordnet sind.

Eine andere bevorzugte Ausführungsform der erfindungsgemäßen Vorrichtung sieht vor, dass die Windungen mindestens einer Spule einen von den übrigen Spulen abweichenden Abstand zu der gedachten Tiegelmittelachse aufweisen.

Eine weitere bevorzugte Ausführungsform der erfindungsgemäßen Vorrichtung sieht vor, dass die Windungen mindestens einer Spule einen von den übrigen Spulen abweichenden Windungsquerschnitt aufweisen.

In einer weiteren bevorzugten Ausführungsform der erfindungsgemäßen Vorrichtung ist vorgesehen, dass der Abstand mindestens einer Windung von der gedachten Tiegelmittelachse zum Innenrand der Windung gegenüber den der anderen Windungen geringer ist.

Eine nächste bevorzugte Ausführungsform der erfindungsgemäßen Vorrichtung ist dadurch gekennzeichnet, dass mindestens ein Windungsquerschnitt der Windungen innerhalb einer Spule gegenüber den weiteren Windungen der Spule unterschiedlich ist.

Erfindungsgemäß kann der Windungsquerschnitt der Windungen innerhalb einer Spule unterschiedlich sein. Der Windungsquerschnitt kann sich innerhalb einer Spule verringern oder vergrößern.

Eine weitere bevorzugte Ausführungsform der erfindungsgemäßen Vorrichtung sieht vor, dass die Windungen der Spulen aus unterschiedlichen Materialien bestehen.

In einer anderen bevorzugten Ausführungsform der erfindungsgemäßen Vorrichtung ist vorgesehen, dass die Spulen eine unterschiedliche Anzahl von Windungen aufweisen.

Eine nächste bevorzugte Ausführungsform der erfindungsgemäßen Vorrichtung ist dadurch gekennzeichnet, dass die Spulen eine gleiche Anzahl von Windungen aufweisen.

Eine weitere bevorzugte Ausführungsform der erfindungsgemäßen Vorrichtung sieht vor, dass der Windungsquerschnitt die Form einer beliebigen geometrischen Fläche aufweist.

In einer anderen bevorzugten Ausführungsform der erfindungsgemäßen Vorrichtung ist vorgesehen, dass der Windungsquerschnitt eine rechteckige, quadratische oder runde Form aufweist.

In einer anderen bevorzugten Ausführungsform der erfindungsgemäßen Vorrichtung ist vorgesehen, dass eine von den Windungen umschlossene Fläche die Form einer beliebigen geometrischen Fläche aufweist.

Dabei ist "die von einer Windung umschlossene Fläche" jene Fläche, die man erkennt, wenn man die Windung in Blickrichtung der gedachten Tiegelmittelachse betrachtet und dann die Fläche betrachtet, die von der Windung umschlossen wird; also die Fläche, die sich ergibt, wenn man von der Projektion der Windungsinnenseite der kompletten Windung auf eine Ebene senkrecht zur gedachten Tiegelmittelachse ausgeht, und dann die von dieser Projektion in der Ebene umschlossene Fläche betrachtet.

Möglich ist, dass die von den Windungen umschlossene Fläche eine rechteckige, quadratische oder runde Form aufweist.

Durch das erfindungsgemäße Verfahren zur Herstellung von Kristallen aus elektrisch leitenden Schmelzen mittels einer Vorrichtung nach mindestens einem der Ansprüche 1 bis 12, wobei in einer in einem Tiegel enthaltene Schmelze durch eine aus Spulen aufgebaute Mehrspulenanordnung ein Lorentzkraftfeld mit einem im Bereich einer Tiegelwand aufweisenden Lorentzkraftdichtemaximum erzeugt wird, wird erreicht, dass das Lorentzkraftdichtemaximum vom Bereich der Tiegelwand durch Steuerung der in die Spulen eingespeisten Größen Stromstärke, Phasenverschiebung und Frequenz zu einer gedachten Tiegelmittelache hin verschoben wird.

Die Lorentzkraftverteilung in der Schmelze durch Steuerung der in die Spulen eingespeisten Größen Stromstärke, Phasenverschiebung und Frequenz wird so modifiziert, dass sich die Verteilung besser zur Beeinflussung der Schmelzströmung eignet, indem unter anderem das Lorentzkraftdichtemaximum vom Bereich der Tiegelwand zur einer gedachten Tiegelmittelachse hin verschoben wird. Dabei kann auch eine Vorrichtung nach dem Stand der Technik mit einer üblichen zylindrisch angeordneten Heizeinrichtung, bei der die Abstände der Windungen von einer gedachten Tiegelmittelachse zur Innenwand der Windungen gleich bleibt, verwendet werden. Hier werden lediglich die Größen Stromstärke, Phasenverschiebung und Frequenz modifiziert.

In einer bevorzugten Ausführungsform des erfindungsgemäßen Verfahrens ist vorgesehen, dass in mindestens einer Spule eine von den übrigen Spulen abweichende Phasenverschiebung eingespeist wird.

Eine weitere bevorzugte Ausführungsform des erfindungsgemäßen Verfahrens sieht vor, dass in den Spulen die gleichen Phasenverschiebungen eingespeist werden.

Erfindungsgemäß ist vorgesehen, dass mindestens für ein Paar von direkt über bzw. nebeneinander liegenden Spulen die Phasenverschiebung zwischen den an den beiden Spulen angelegte Spannung von mindestens einer der Phasenverschiebung abweicht, die sich für die verbleibenden Spulenpaare ergeben.

Als Spulenpaare kommen bei einer Heizeinrichtung bestehend aus drei übereinander angeordneten Spulen, die obere und die mittlere Spule sowie die mittlere und die untere Spule in Betracht. Besitzt die Heizeinrichtung weitere unterhalb des Tiegelbodens angeordnete Spulen, dann kommen als Spulenpaare auch weitere Kombinationen mit diesen Spulen in Betracht.

Alternativ hat bei mindestens einem Paar von direkt über bzw. nebeneinander angeordneten Spulen die Phasenverschiebung zwischen den an diesen beiden Spulen angelegte Spannung ein anderes Vorzeichen als die Phasenverschiebung von mindestens einer der verbleibenden Spulenpaare. So kann sich für mindestens ein Spulenpaar die Phasenverschiebung im Vorzeichen von den Phasenverschiebungen für die verbleibenden Spulen unterscheiden.

Weiterhin ist vorgesehen, dass für alle Paare von direkt über bzw. nebeneinander liegenden Spulenpaare die gleiche Phasenverschiebung zwischen den an diesen beiden Spulen angelegte Spannung vorliegt.

Eine weitere bevorzugte Ausführungsform des erfindungsgemäßen Verfahrens ist dadurch gekennzeichnet, dass in mindestens einer Spule eine von den übrigen Spulen abweichende Stromstärke eingespeist wird.

Eine andere bevorzugte Ausführungsform des erfindungsgemäßen Verfahrens sieht vor, dass in den Spulen jeweils gleich große Stromstärken eingespeist werden.

In einer nächsten bevorzugten Ausführungsform des erfindungsgemäßen Verfahrens ist dadurch gekennzeichnet, dass mindestens eine Spule mit einer höheren Stromstärke gegenüber den übrigen Spulen betrieben wird.

In einer nächsten bevorzugten Ausführungsform des erfindungsgemäßen Verfahrens ist dadurch gekennzeichnet, dass mindestens eine Spule mit einer niedrigeren Stromstärke gegenüber den übrigen Spulen betrieben wird.

Eine weitere bevorzugte Ausführungsform des erfindungsgemäßen Verfahrens ist dadurch gekennzeichnet, dass in mindestens eine Spule eine von den übrigen Spulen abweichende Frequenz eingespeist wird.

Eine andere bevorzugte Ausführungsform des erfindungsgemäßen Verfahrens sieht vor, dass in die Spulen jeweils die gleiche Frequenz eingespeist wird.

In einer nächsten bevorzugten Ausführungsform des erfindungsgemäßen Verfahrens ist vorgesehen, dass die Steuerung der Größen Phasenverschiebung, Stromstärke und Frequenz mit einer hohlzylindrischen Mehrspulenanordnung erfolgt.

Im Folgenden wird ein Ausführungsbeispiel der Erfindung anhand von Zeichnungen näher erläutert.

Es zeigen
- Fig. 1:: einen schematischen Querschnitt durch eine Kristallzüchtungsanlage, mit drei übereinander angeordneten Spulen nach dem Stand der Technik,
- Fig. 2:: einen schematischen Querschnitt durch eine Kristallzüchtungsanlage mit drei übereinander angeordneten Spulen, wobei sich der Abstand der Windungen zu einer gedachten Tiegelmittelachse verringert und wobei die Windungsquerschnitte gleich bleiben,
- Fig. 3:: eine schematische Darstellung einer Heizeinrichtung mit drei übereinander angeordneten Spulen, wobei sich der Abstand der Windungen zu einer gedachten Tiegelmittelachse verringert und wobei die Windungsquerschnitte gleich bleiben,
- Fig. 4:: einen schematischen Querschnitt durch eine Kristallzüchtungsanlage mit drei übereinander angeordneten Spulen mit gleichbleibenden Abstand der Windungen zu einer gedachten Tiegelmittelachse und verbreitertem rechteckigen Windungsquerschnitt der Windungen einer Spule,
- Fig. 5:: eine schematische Darstellung einer Heizeinrichtung mit drei übereinander angeordneten Spulen mit gleichbleibenden Abstand der Windungen zu einer gedachten Tiegelmittelachse und verbreitertem rechteckigen Windungsquerschnitt der Windungen einer Spule,
- Fig. 6:: einen schematischen Querschnitt einer Kristallzüchtungsanlage mit drei übereinander angeordneten Spulen mit gleichbleibenden Abstand der Windungen zu einer gedachten Tiegelmittelachse und weiteren unterhalb des Tiegelbodens angeordneten Spulen innerhalb der übereinander angeordneten Spulen,
- Fig. 7:: eine schematische Darstellung einer Heizeinrichtung mit drei übereinander angeordneten Spulen mit gleichbleibenden Abstand der Windungen zu einer gedachten Tiegelmittelachse und weiteren unterhalb des Tiegelbodens angeordneten Spulen,
- Fig. 8:: einen schematischen Querschnitt einer Kristallzüchtungsanlage mit drei übereinander angeordneten Spulen, wobei die Windungen einer Spule einen sich verringernde Abstand zu einer gedachten Tiegelmittelachse aufweisen,
- Fig. 9:: eine schematische Darstellung einer Heizeinrichtung mit drei übereinander angeordneten Spulen, wobei die Windungen einer Spule, einen sich verringernden Abstand zu einer gedachten Tiegelmittelachse aufweisen,
- Fig. 10:: eine schematische Darstellungen einer Kristallzüchtungsanlage mit drei übereinander angeordneten Spulen nach dem Stand der Technik für Simulationsrechnungen und den Monitorpunkten g bis I,
- Fig. 11:: eine schematische Darstellungen einer Kristallzüchtungsanlage mit drei übereinander angeordneten Spulen und einer Spule mit geringerem
- Fig. 12:: Abstand der Windungen zur Tiegelmittelachse für Simulationsrechnungen und den Monitorpunkten g bis l, eine schematische Darstellungen einer Kristallzüchtungsanlage mit drei übereinander angeordneten Spulen und einer Spule mit größerem Abstand der Windungen zur Tiegelmittelachse für Simulationsrechnungen und den Monitorpunkten g bis I,
- Fig. 13:: eine schematische Darstellungen einer Kristallzüchtungsanlage mit drei übereinander angeordneten Spulen mit unterschiedlichen Abständen der Windungen innerhalb der Spulen zur Tiegelmittelachse für Simulationsrechnungen und den Monitorpunkten g bis I,
- Fig. 14:: eine schematische Darstellungen einer Kristallzüchtungsanlage mit drei übereinander angeordneten Spulen mit verbreitertem Windungsquerschnitt einer Spule für Simulationsrechnungen und den Monitorpunkten g bis l,
- Fig. 15:: eine schematische Darstellungen einer Kristallzüchtungsanlage mit drei übereinander angeordneten Spulen mit verbreitertem Windungsquerschnitt der oberen und unteren Spule für Simulationsrechnungen und den Monitorpunkten g bis l,
- Fig. 16:: eine schematische Darstellungen einer Kristallzüchtungsanlage mit drei übereinander angeordneten Spulen und mit verbreitertem Windungsquerschnitt aller Spulen für Simulationsrechnungen und den Monitorpunkten g bis l,
- Fig. 17:: eine schematische Darstellungen einer Kristallzüchtungsanlage mit drei übereinander angeordneten Spulen für Simulationsrechnungen mit den Monitorpunkten a bis f,
- Fig. 18:: eine schematische Darstellungen einer Kristallzüchtungsanlage mit zwei übereinander angeordneten Spulen und einer unterhalb des Tiegels angeordneten Spule für Simulationsrechnungen und den Monitorpunkten a bis f,
- Fig. 19.: eine schematische Darstellungen einer Kristallzüchtungsanlage mit drei Spulen mit einer mittleren teilweise unterhalb des Tiegels angeordneten Spule für Simulationsrechnungen und den Monitorpunkten a bis f,
- Fig. 20:: eine schematische Darstellung der Aufsicht auf eine Kristallzüchtungsanlage,
- Fig. 21:: eine schematische Darstellung der Aufsicht auf eine Kristallzüchtungsanlage wie in Fig. 20, mit Markierung einer von der Windung umschlossene runden Fläche,
- Fig. 22:: eine weitere schematische Darstellung der Aufsicht auf eine Kristallzüchtungsanlage,
- Fig. 23:: eine schematische Darstellung der Aufsicht auf eine Kristallzüchtungsanlage wie in Fig. 22, mit Markierung einer von der Windung umschlossene quadratischen Fläche.

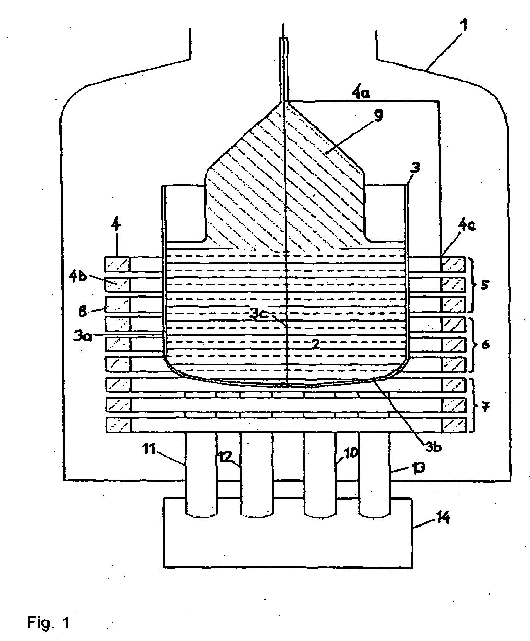

In Fig. 1 wird eine schematische Darstellung einer Kristallzüchtungsanlage im Querschnitt nach dem Stand der Technik gezeigt. In einer Züchtungskammer 1 befindet sich eine Heizeinrichtung 4. ein Tiegel 3 mit einer Tiegelwand 3a, einem Tiegelboden 3b und einer gedachten Tiegelmittelachse 3c, der von drei übereinander angeordneten Spulen 5, 6, 7 vollständig umgeben ist. Die Heizeinrichtung 4 ist aus diesen drei axial übereinander angeordneten Spule 5, 6, 7 aus Graphit mit jeweils 3 Windungen aufgebaut Gezeigt werden auch eine sich im Tiegel befindende Schmelze 2 und ein gezogener Kristall 9. Die Windungen 8 der Spulen 5, 6, 7 weisen jeweils einen gleichbleibenden Windungsquerschnitt 4b auf. Der Abstand 4a der Windungen 8 von einer gedachten Tiegelmittelachse 3c zum Innenrand 4c der Windungen 8 ist ebenfalls konstant, so dass die als Mehrspulenanordnung aufgebaute Heizeinrichtung 4 eine gleichbleibende hohlzylindrische Form aufweist. Die Spulen 5, 6, 7 sind über die Spulenanschlüsse 10, 11, 12, 13 durch die Züchtungskammer 1 mit einer Energieversorgungseinrichtung 14 elektrisch verbunden und können über Spulenanschlüsse 10, 11, 12, 13 an eine Wechselstromquelle als Energieversorgungseinrichtung 14 angeschlossen werden.

Bei der Anordnung nach dem Stand der Technik nach Fig. 1 befindet sich das berechnete Maximum der simulierten Lorentzkraftdichte im Bereich des Tiegelrandes, d. h. im Bereich der Tiegelwand 3a. Die axiale Position ist nur beeinflussbar über die Position des Tiegels 3 in der Heizeinrichtung 4. Eine Verschiebung der Lorentzkraftdichte in Richtung einer gedachten Tiegelmittelachse 3c bzw. eine lokale Verstärkung der Magnetkraft ist hier nicht möglich.

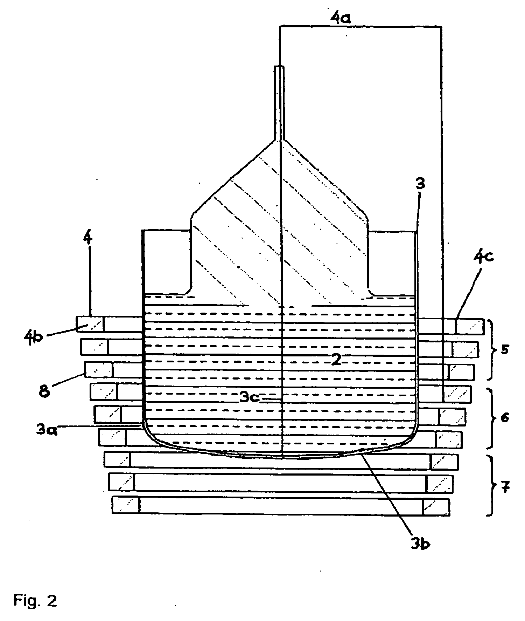

In Fig. 2 wird eine schematische Darstellung einer Kristallzüchtungsanlage im Querschnitt gezeigt, deren Heizeinrichtung 4 aus drei übereinander angeordneten Spulen 5, 6, 7. mit gleichbleibendem Windungsquerschnitt 4b aufgebaut ist. Die Windungen 8 der Spulen 5, 6, 7 weisen im Gegensatz zu denen in Fig. 1 einen sich verringernden Abstand 4a bezogen auf die Innenwand 4c der Windungen 8 zu der gedachten Tiegelmittelachse 3c auf. Der Abstand 4a verringert sich auch innerhalb der Spulen 5, 6, 7. Die Windungen 8 der Heizeinrichtung 4 umschließen den Tiegel 3 im Bereich des Tiegelbodens 3b am engsten.

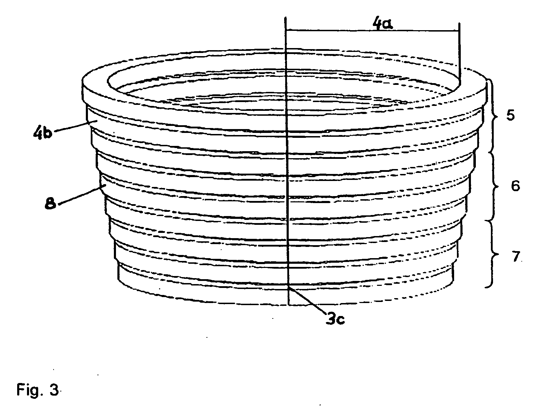

Fig. 3 zeigt die schematische Darstellung einer Heizeinrichtung 4 aus drei übereinander angeordneten Spulen 5, 6, 7 mit gleichbleibendem Windungsquerschnitt 4b nach Fig. 2.

Aus Simulationsrechnungen der Verteilung der Lorentzkraft in einer elektrisch leitenden Schmelze wird ersichtlich, dass in den in den Fig. 2 und 3 beschriebenen Anordnungen die maximale Lorentzkraftdichte etwas vom Tiegelrand (Tiegelwand 3a) in Richtung der gedachten Tiegelmittelachse 3c im unteren Bereich der Schmelze verschoben werden kann. Weiterhin kommt es zu einer lokalen Verstärkung der Kraft im Bereich des Tiegelbodens 3b durch die Verringerung des Abstandes 4a von der gedachten Tiegelmittelachse 4a zum Innenrand 4c der Spulenwindung 8 im Bereich der Spulen 6 und 7. Diese gezielte Verschiebung der maximalen Lorentzkraftdichte ermöglicht eine effektivere Beeinflussung der thermisch bedingten Auftragskonvektion in der Schmelze.

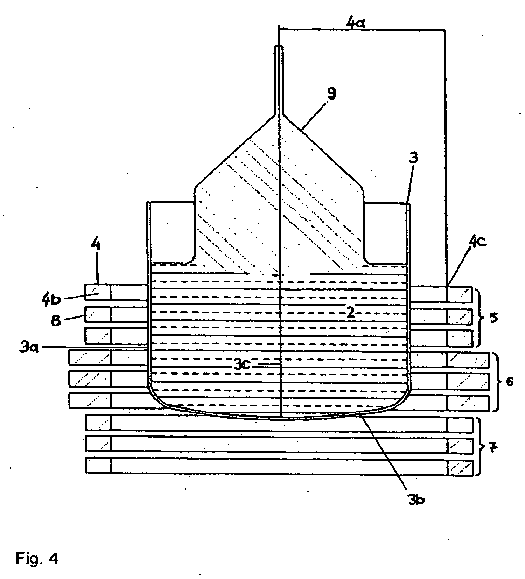

In Fig. 4 wird eine schematische Darstellung einer Kristallzüchtungsanlage im Querschnitt mit drei übereinander angeordneten Spulen 5, 6 und 7 gezeigt, wobei hier der Windungsquerschnitt 4b einer Spule 6 gegenüber dem der übrigen Spulen 5, 7 vergrößert ist. Die Windungen 8 der mittleren Spule 6 weisen einen verbreiterten rechteckigen Windungsquerschnitt 4b auf, während der Abstand 4a der Windungen 8 bezogen auf die gedachte Tiegelmittelachse 3c zum Innenrand 4c bei allen Spulen 5, 6, 7 gleich bleibt.

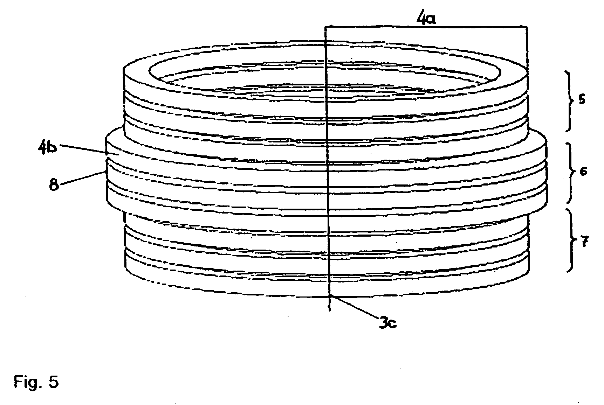

Fig. 5 stellt die schematische Darstellung einer Heizeinrichtung 4 nach der Fig. 4 dar, bei der die Windungen 8 die mittleren Spule 6 einen verbreiterten Windungsquerschnitt 4b besitzen.

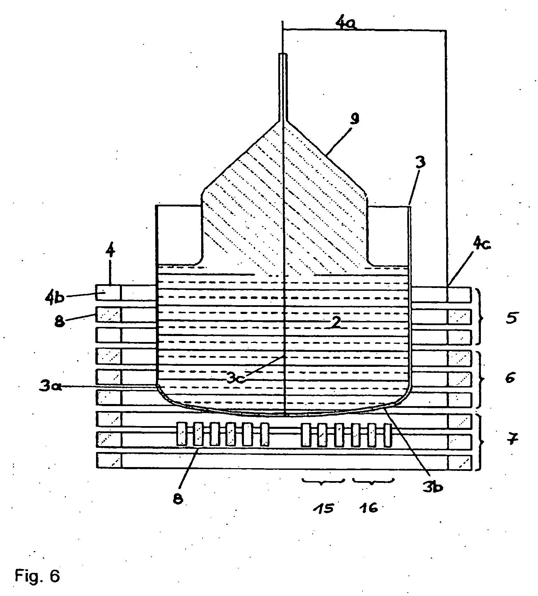

In Fig. 6 wird eine schematische Darstellung einer Kristallzüchtungsanlage im Querschnitt mit drei übereinander angeordneten Spulen 5, 6 und 7 und jeweils gleichbleibenden Windungsquerschnitt 4b der Spulen 5, 6, 7 gezeigt, wobei hier zwei weitere Spulen 15 und 16 unterhalb des Tiegelbodens 3b angeordnet sind. Bei den Spulen 15 und 16 sind die Windungen 8 ineinander angeordnet, und beide Spulen befinden sich in Höhe der Windung 7.

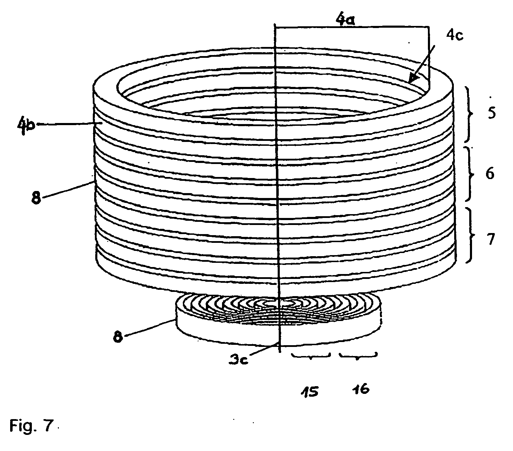

Fig. 7 zeigt die schematische Darstellung einer Heizeinrichtung 4 ähnlich zu der der in Fig. 6, allerdings sind hier die Spulen 15 und 16 weiter unten angeordnet Die jeweils unter dem Tiegelboden 3b angeordneten Spulen 15 und 16 weisen gegenüber den Spulen 5, 6 und 7 einen geringeren Windungsquerschnitt 4b auf.

Mit den erfindungsgemäßen Anordnungen nach den Fig. 6 und 7 kann eine Verschiebung des Maximums der axialen Lorentzkraftdichteverteilung vom Tiegelrand bzw. der Tiegelwand 3a in Richtung der gedachten Tiegelmittelachse 3c erreicht werden. Dies ermöglicht eine effektive Beeinflussung der auftretenden thermischen Konvektion, insbesondere im Bereich unter dem Kristall 9, welche für die Stabilisierung des Einkristallwachstums von großer Bedeutung ist. Die beschriebenen Anlagen sind besonders für Anordnungen mit hoher Schmelze 2 und mit besonders starker Auftriebskonvektion geeignet.

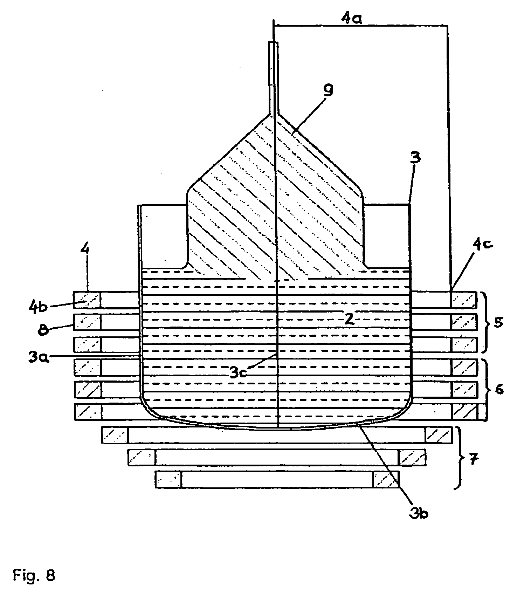

Die schematische Darstellung einer Kristallzüchtungsanlage nach Fig. 8 zeigt eine Mehrspulenanordnung mit drei übereinander angeordneten Spulen 5, 6 und 7, wobei hier der Abstand 4a der Windungen 8 bezogen auf eine gedachte Tiegelmittelachse 3c zum Innenrand der Windungen 8 nur jeweils einer Spule 7, nämlich der der untersten, verringert. Der Windungsquerschnitt 4b der Windungen 8 der Spulen 5, 6, 7 bleibt gleich.

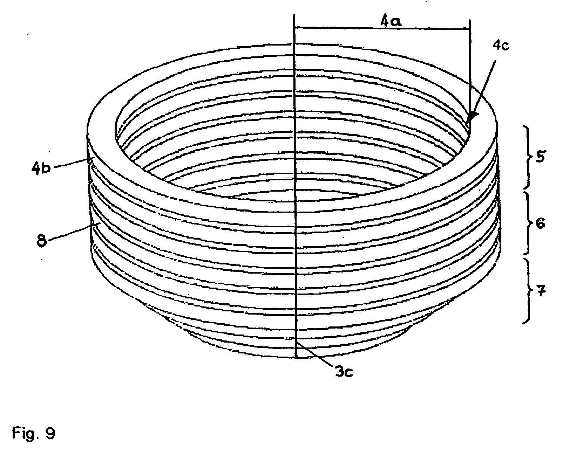

Fig. 9 stellt die schematische Darstellung einer Heizeinrichtung 4 entsprechend der Fig. 8 mit einem sich verringernden Abstand 4a der Windungen 8 bezogen auf eine gedachte Tiegelmittelachse 3c zum Innenrand der Windungen 8 der untersten Spule 7 dar.

Mit den erfindungsgemäßen Anordnungen nach den Fig. 8 und 9 kann eine gezielte Verschiebung des Maximums der Lorentzkraftdichte in der elektrisch leitenden Schmelze 2 vom Tiegelrand - der Tiegelwand 3a - erreicht werden. Durch Variation des Abstandes 4a von der gedachten Tiegelmittelachse 3c ist die Position der maximalen Kraftwirkung, welche die Auftriebkonvektion gezielt eindämmen kann, einstellbar.

Aus Simulationsrechnungen der Verteilung der Lorentzkraft in einer elektrisch leitenden Schmelze wird ersichtlich, dass in der erfindungsgemäßen Vorrichtungen die maximale Lorentzkraft vom Bereich der Tiegelwand 3a - am Tiegelrand -, in Richtung der Tiegelmittelachse 3c im unteren Bereich der Schmelze verschoben wird. Diese radiale Verschiebung der maximalen Lorentzkraftdichte ermöglicht eine effektivere Beeinflussung der Auftragskonvektion.

Zur Verschiebung des Maximums der Lorentzkraftdichte vom Bereich der Tiegelwand 3a zur Tiegelmittelachse 3c, also zum Tiegelinneren, werden die Größen Stromstärke I [A], Phasenwinkel ϕ [°] und Frequenz f [Hz] in den Spulen 5, 6, 7 der Heizeinrichtung 4, sowie die Form der Heizeinrichtung 4 variiert.

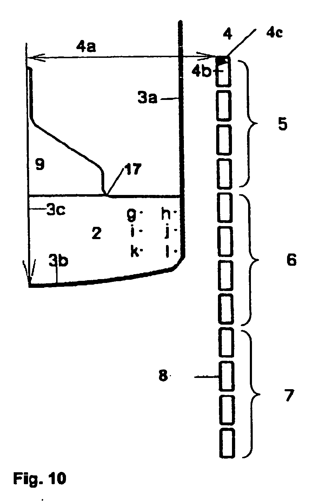

Im Folgenden werden anhand der Vorrichtungen nach den Fig. 10 bis 19 Simulationsrechnungen für Steuerungsvarianten für die Einspeisung der Größen Stromstärke I [A], Phasenwinkel ϕ [°] und Frequenz f [Hz] in die Spulen 5, 6, 7der erfindungsgemäßen Vorrichtungen für die Beeinflussung der Lorentzkraft in der Schmelze 2 durchgeführt. Die Monitorpunkte a bis I bezeichnen dabei die entsprechenden Messwerte für die Lorentzkraftdichte in der Schmelze 2.

Zur Modifikation der Lorentzkraftdichte, insbesondere zur Verschiebung des Maximums vom Bereich der Tiegelwand 3a zur Tiegelmittelachse 3c, also zum Tiegelinneren, werden die Größen Stromstärke I [A], Phasenwinkel ϕ [°] und Frequenz f [Hz] in den Spulen 5, 6, 7 der Heizeinrichtung 4 variiert.

Bei den Simulationsrechnungen nach den Vorrichtungen gemäß den Fig. 10 bis 16 wird die in die Heizeinrichtung 4 eingespeiste Leistung so gewählt, dass sich am Tripelpunkt 17 - Punkt, bei dem die feste, flüssige und gasförmige Phase im Gleichgewicht steht - die Schmelztemperatur von GaAs, das sind 1511 K, einstellt. Es wird simuliert, welche elektromagnetischen Felder sich ergeben, wenn man mit einer Vorrichtung bestehend aus drei übereinander angeordneten Spulen 5, 6 und 7 geeignete Wechselspannungen mit einer Frequenz von 300 Hz anlegt.

Die Simulationen zeigen, dass man Stärke und Form der in der Schmelze 2 wirkenden Lorentzkräfte verändern kann, um sie in einer für die jeweils vorliegende Züchtungskonfiguration vorteilhafte Form zu bringen.

Dabei kann es unterschiedliche Möglichkeiten geben, eine bestimmte Kraftänderung zu erhalten.

Bei einer ersten Simulation, durchgeführt mit einer Vorrichtung nach Fig. 10, besteht die Vorrichtung aus einer Heizeinrichtung 4 aus drei übereinander angeordneten Spulen 5, 6 und 7 mit jeweils vier Windungen 8. Der Abstand 4a der Windungen 8 bezogen auf eine gedachte Tiegelmittelachse 3c und dem Innenrand 3c der Windungen 8 sowie die Windungsquerschnitte 4b sind bei dieser Anordnung gleich. An alle Spulen 5, 6 und 7 wird eine Spannung mit der gleichen Amplitude angelegt und die Phasenverschiebung zwischen der oberen Spule 5 und der mittleren Spule 6 beträgt -70°. Ebenso beträgt die Phasenverschiebung zwischen den Spannungen, die an die mittlere Spule 6 und an die untere Spule 7 angelegt werden -70°.

Um am Tripelpunkt 17 die Temperatur von 1511 K zu erhalten, muss insgesamt eine Leistung von 5,4 kW eingespeist werden, die sich fast gleichmäßig auf die zwölf Windungen 8 aufteilt, so dass in jede Windung 8 ca. 450 W Leistung eingespeist werden.

Für die Monitorpunkte g, h, i, j, k und I werden die gemessenen Lorentzkraftdichten in Tabelle 1 angegeben.

**Tabelle 1:**

| Monitorpunkt | Lorentzkraftdichte [N/m³] horizontal | Lorentzkraftdichte [N/m³] vertikal |
|---|---|---|
| g | 26,106 | -46,272 |
| h | -68,311 | -87,569 |
| i | -30,966 | -32,601 |
| j | -85,737 | -66,465 |
| k | -34,645 | -15,362 |
| l | -91,229 | -39,035 |

In einer zweiten Simulation - ebenfalls durchgeführt mit einer Vorrichtung nach Fig. 10 - werden die eingespeisten Phasenverschiebungen und die an den Spulen angelegten Spannungen variiert.

Die Phasenverschiebung zwischen der oberen Spule 5 und der an der mittleren Spule 6 angelegten Spannung beträgt -100°, während die Phasenverschiebung zwischen den Spannungen, die an die mittlere Spule 6 und an die untere Spule 7 angelegt werden, beträgt -40°. Die eingespeisten Leistungen entsprechen denen aus der ersten Simulation.

In einer dritten Simulation mit einer Anordnung nach Fig. 10 ist die an die mittlere Spule 6 angelegte Spannung doppelt so hoch wie die an je eine der beiden anderen Spulen 5 und 7. Dies führt dazu, dass in der mittleren Spule 6 doppelt so viel Strom fließt und eine viermal höhere Leistung vorliegt wie in der oberen Spule 5 bzw. in der unteren Spule 7. Von den rund 5,3 kW Leistung, die zum Ansteuern der 1511 K am Tripelpunkt 17 eingespeist werden müssen, entfallen auf die vier Windungen der mittleren Spule 6 je ca. 880 W und auf die insgesamt acht Windungen der oberen 5 und der unteren Spule 7 entfallen je 220 W. Die Phasenverschiebungen zwischen den Spannungen an der oberen Spule 5 und der mittleren Spule 6 beträgt -70°, ebenso die Phasenverschiebung zwischen den Spannungen an der mittleren Spule 6 und der unteren Spule 7.

In Tabelle 2 werden die sich ergebenden Lorentzkraftdichten an den Monitorpunkten g bis I zusammengefasst.

**Tabelle 2:**

| Monitorpunkt | Lorentzkraftdichte [N/m³] horizontal bei unterschiedlichen Phasendifferenzen | Lorentzkraftdichte [N/m³] vertikal bei unterschiedlichen Phasendifferenzen | Lorentzkraftdichte [N/m³] horizontal bei unterschiedlichen Spannungen | Lorentzkraftdichte [N/m³] vertikal bei unterschiedlicher Spannungen |
|---|---|---|---|---|
| g | -18,396 | -36,164 | -39,271 | -44,874 |
| h | -47,463 | -75,351 | -104,201 | -80,063 |
| i | -24,192 | -25,294 | -47,500 | -25,136 |
| j | -67,389 | -57,528 | -135,908 | -52,131 |
| k | -29,636 | -8,874 | -52,712 | -1,403 |
| l | -79,405 | -28,962 | -143,354 | -15,921 |

Durch die unterschiedlichen Phasendifferenzen werden die Stärke und Richtung der Lorentzkraftdichte modifiziert. Das Anlegen einer höheren Spannung an die mittlere Spule 6 sorgt dafür, dass die Kraft stärker wird und mehr in die horizontale Richtung zeigt.

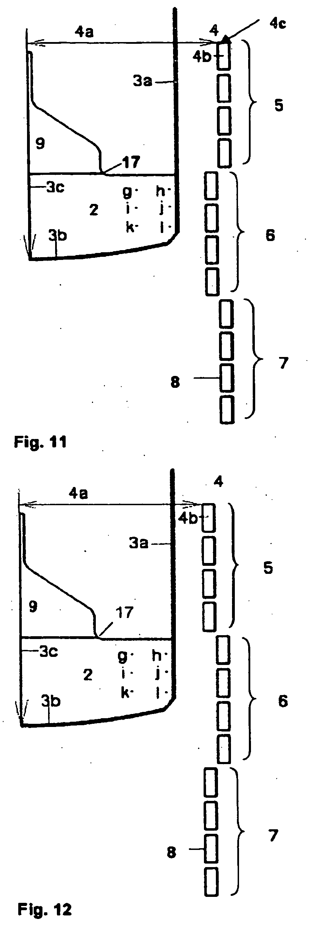

In einer vierten Simulation, durchgeführt mit einer Vorrichtung nach Fig. 11, werden die Abstände 4a der Windungen 8 von einer gedachten Tiegelmittelachse 3c zum Innenrand 4c der Windungen 8 der Spulen 5, 6 und 7 variiert.

Die Vorrichtung nach Fig. 11 besteht aus einer Heizeinrichtung 4 aus drei übereinander angeordneten Spulen 5, 6 und 7 mit jeweils vier Windungen 8, wobei hier der Abstand 4a der Windungen 8 bezogen auf eine gedachte Tiegelmittelachse 3c zum Innenrand 4c der Windungen 8 der mittleren Spule 6 kleiner ist als der der übrigen Spulen 5 und 7. Da sich somit der Umfang der mittleren Spule 6 verkleinert und damit auch der elektrische Widerstand der Spule 6 verringert, wird, bei gleicher angelegter Spannung in die mittlere Spule 6 etwas mehr Leistung eingespeist als in die obere Spule 5 und untere Spule 7. Von den rund 5,4 kW Leistung, die zum Ansteuern der 1511 K am Tripelpunkt 17 eingespeist werden müssen, entfallen auf die vier Windungen 8 der mittleren Spule 6 je rund 470 W und auf die insgesamt acht Windungen der oberen Spule 5 und der unteren Spule 7 je 440 W.

Die Phasenverschiebungen zwischen der oberen Spule 5 und der mittleren Spule 6 beträgt -70°, ebenso die Phasenverschiebung zwischen der mittleren Spule 6 und der unteren Spule 7.

In einer fünften Simulation, durchgeführt mit einer Vorrichtung nach Fig. 12, besteht diese aus einer Heizeinrichtung 4 aus drei übereinander angeordneten Spulen 5, 6 und 7 mit jeweils vier Windungen 8, wobei hier der Abstand 4a der Windungen 8 bezogen auf eine gedachte Tiegelmittelachse 3c zum Innenrand 4c der Windungen 8 der mittleren Spule 6 größer ist als der der übrigen Spulen 5 und 7. Da sich der Umfang der oberen Spule 5 und der unteren Spule 7 verkleinert und sich damit auch der elektrische Widerstand der Spulen 5 und 7 verringert hat, wird, bei gleicher angelegter Spannung, in jede dieser Spulen mehr Leistung eingespeist als in die mittlere Spule 6. Von den rund 5,4 kW Leistung, die zum Ansteuern der 1511 K am Tripelpunkt 17 eingespeist werden müssen, entfallen auf die vier Windungen der mittleren Spule 6 je rund 430 W, auf die insgesamt acht Windungen 8 der oberen Spule 5 und der unteren Spule 7 entfallen je rund 465 W.

Die Phasenverschiebungen zwischen der oberen Spule 5 und der mittleren Spule 6 beträgt -70°, ebenso die Phasenverschiebung zwischen der mittleren Spule 6 und der unteren Spule 7.

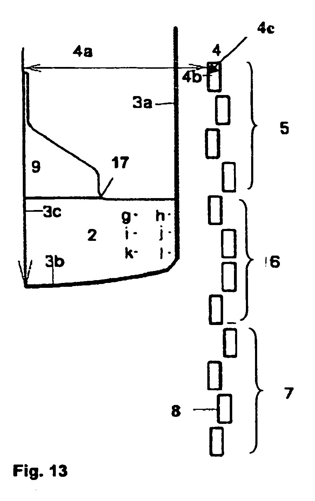

Eine sechste Simulation wurde mit einer Vorrichtung nach Fig. 13 durchgeführt, bei der auch innerhalb der einzelnen Spulen der Abstand 4a von der gedachten Tiegelmittelachse 3c zum Innenrand 4c der Windungen 8 wechselt, d. h. sich verringert oder vergrößert. Von den rund 5,4 kW Leistung, die zum Ansteuern der 1611 K am Tripelpunkt 17 eingespeist werden müssen, entfallen auf die vier Windungen 8 der oberen Spule 5 jetzt 442 W auf die oberste Windung, 461 W, 438 W und 475 W auf die unterste Windung 8 der Spule 5. Auf die vier Windungen der mittleren Spule 6 entfallen 432 W auf die oberste Windung dieser Spule, weitere 461 W, 461 W und 432 W auf die unterste Windung 8 der Spule 6. Schließlich entfallen auf die vier Windungen 8 der unteren Spule 7 469 W auf die oberste Windung 8, weitere 432 W, 455 W und 437 W für die unterste Windung 8 der Spule 7.

Die Phasenverschiebungen zwischen der oberen Spule 5 und der mittleren Spule 6 beträgt -70°, ebenso die Phasenverschiebung zwischen der mittleren Spule 6 und der unteren Spule 7.

Für die Monitorpunkte g, h, i, j, k und I werden die gemessenen Lorentzkraftdichten in Tabelle 3 zusammengefasst.

**Tabelle 3:**

| Monitorpunkte | Lorentzkraftdichten [N/m³] | | | | | | | |
|---|---|---|---|---|---|---|---|---|
| | nach Fig. 10 (Vergleich) | | Abstand 4a Spule 6 kleiner | | Abstand 4a Spule 6 größer | | Abstände 4a innerhalb der Spulen wechseln | |
| | horizontal | vertikal | horizontal | vertikal | horizontal | vertikal | horizontal | vertikal |
| g | -26,106 | -46,272 | -29,088 | -44,894 | -22,775 | -46,144 | -24,169 | -43,773 |
| h | -68,311 | -87,569 | -77,287 | -84,424 | -58,363 | -87,452 | -63,133 | -81,185 |
| i | -30,966 | -32,601 | -34,110 | -29,524 | -26,221 | -33,246 | -28,456 | -30,609 |
| j | -85,737 | -66,456 | -98,088 | -63,263 | -71,5511 | -66,655 | -79,371 | -62,325 |
| k | -34,645 | -15,362 | -39,372 | -11,567 | -29,637 | -17,648 | -31,735 | -14,191 |
| l | -91,229 | -39,035 | -104,339 | -34,959 | -77,397 | -41,280 | -81,732 | -36,195 |

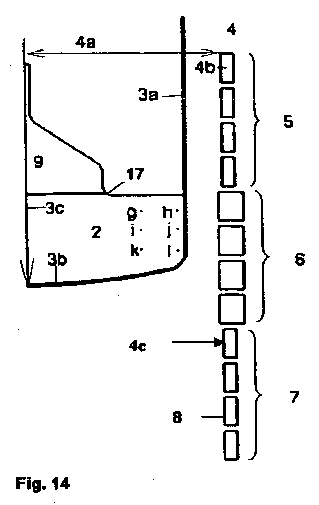

In einer weiteren siebenten Simulation, durchgeführt mit einer Vorrichtung nach Fig. 14 wird der Windungsquerschnitt 4b der Spulen in der Heizeinrichtung variiert.

In einer Vorrichtung nach Fig. 14 sind die Windungen 8 der mittleren Spule 6 verbreitert gegenüber den Windungen der übrigen Spulen 5 und 7, d. h. der Windungsquerschnitt 4b der mittleren Spule 6 ist bei dieser Anordnung größer als der der anderen Spulen. Die angelegte Spannung wird so gewählt, dass in allen drei Spule 5, 6 und 7 in etwa die gleiche Heizleistung vorliegt. Es entfallen von den rund 5,4 kW die zum Ansteuern der 1511 K am Tripelpunkt 17 eingespeist werden müssen, auf die vier Windungen der oberen Spule 5 ca. 455 W, auf die vier Windungen der mittleren Spule 6 entfallen je ca. 444 W und auf die vier Windungen der unteren Spule 7 entfallen je ca. 447 W.

Die Phasenverschiebungen zwischen der oberen Spule 5 und der mittleren Spule 6 beträgt-70°, ebenso die Phasenverschiebung der mittleren Spule 6 und der unteren Spule 7.

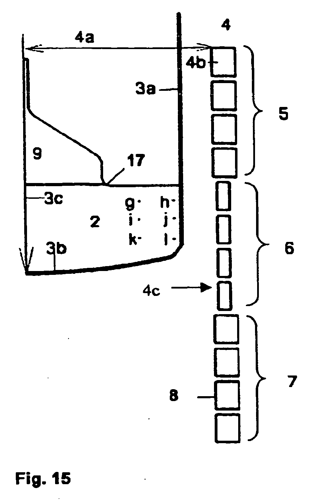

In einer achten Simulation mit einer Vorrichtung nach Fig. 15 wurde der Windungsquerschnitt 4b der Spulen in der Heizeinrichtung weiter variiert.

In einer Vorrichtung nach Fig. 15 sind die Windungen 8 der oberen Spule 5 und die der unteren Spule 7 verbreitert gegenüber den Windungen der mittleren Spule 6, d. h. der Windungsquerschnitt 4b der mittleren Spule 6 ist bei dieser Anordnung kleiner als der der anderen Spulen. Die angelegte Spannung wird so gewählt, dass in jeder dieser beiden Spulen 5 und 7 in etwa die gleiche Heizleistung vorliegt wie in der mittleren Spule 6. Es entfallen von den rund 5,4 kW die zum Ansteuern der 1511 K am Tripelpunkt 17 eingespeist werden müssen, auf die vier Windungen der oberen Spule 5 ca. 452 W, auf die vier Windungen der mittleren Spule 6 entfallen je ca. 451 W und auf die vier Windungen der unteren Spule 7 entfallen je ca. 443 W.

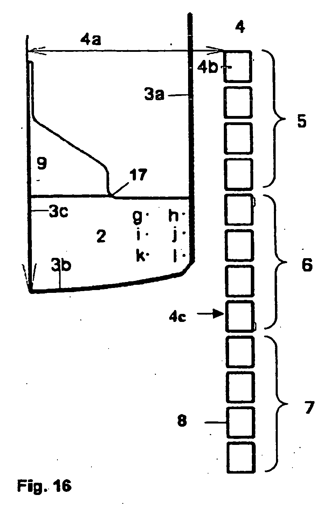

In einer nächsten neunten Simulation nach Fig. 16 wurde eine Vorrichtung gewählt, bei der die Windungen aller Spulen 5, 6 und 7 einen vergrößerten Windungsquerschnitt 4b aufweisen. Von den 5, 4 kW, die zum Ansteuern der 1511 K am Tripelpunkt eingespeist werden müssen, entfallen auf die vier Windungen der oberen Spule 5 je rund 454 W, auf die Windungen 8 der mittleren Spule 6 entfallen je rund 446 W und auf die vier Windungen der unteren Spule entfallen je ca. 443 W. Die Phasenverschiebungen zwischen der oberen Spule 5 und der mittleren Spule 6 beträgt -70°, ebenso die Phasenverschiebung zwischen der mittleren Spule 6 und der unteren Spule 7.

Die sich bei den genannten Anordnungen (Fig. 14 bis 16) ergebenden Lorentzkraftdichten werden in Tabelle 4 zusammengefasst.

**Tabelle 4:**

| Monitorpunkt | Lorentzkraftdichten [N/m³] | | | | | | | |
|---|---|---|---|---|---|---|---|---|
| | nach Fig. 10 | | Windungsquerschnitt 4b mittlere Spule 6 breiter | | Windungsquerschnitt 4b Spule 5 und 7 breiter | | Windungsquerschnitt 4b Spulen 5, 6, 7 breiter | |
| | horizontal | vertikal | horizontal | vertikal | horizontale | vertikal | horizontal | vertikal |
| g | -26,106 | -46,272 | -42,364 | -62,003 | -32,010 | -67,647 | -49,987 | -88,282 |
| h | -68,311 | -87,569 | -111,311 | -114,922 | -82,779 | -128,164 | -129,347 | -166,684 |
| i | -30,966 | -32,601 | -50,731 | -39,120 | -37,131 | -49,779 | -58,745 | -62,015 |
| j | -85,737 | -66,456 | -144,033 | -83,172 | -100,830 | -101,596 | -163,368 | -126,328 |
| k | -34,645 | -15,362 | -58,100 | -12,584 | -41,495 | -29,427 | -66,103 | -29,441 |
| l | -91,229 | -39,035 | -153,259 | -40,083 | -107,376 | -67.459 | -174,120 | -74,762 |

Durch die Verbreiterung des Windungsquerschnittes 4b der mittleren Spule 6 und die dadurch erfolgte Verringerung des Widerstandes dieser Spule kann man auch bei gleichmäßiger Aufteilung der eingespeisten Leistung wie in der Simulation, bei der die mittlere Spule 6 verbreitert wurde, auf die drei Spulen 5, 6 und 7 in der mittleren Spule 6 einen höheren Stromfluss in der mittleren Spule 6 erhalten. Dies ändert die Form des Magnetfeldes und damit die Lorentzkräfte in der Schmelze 2, so dass in der Simulation nach Fig. 14 im Vergleich zur Simulation nach Fig. 10 die horizontale Kraftkomponente deutlich größer ist. Die vertikale Kraftkomponente an den Monitorpunkten g, h und i in der Simulation nach Fig. 14 ist deutlich größer als in der Simulation nach Fig. 10; in den Monitorpunkten j und I nur geringfügig größer und im Monitorpunkt k fällt sie etwas ab.

Bei der Simulation nach Fig. 15 mit einer Vorrichtung mit verbreitertem Windungsquerschnitt 4b der oberen und unteren Spulen 5 und 7 und bei gleichmäßiger Aufteilung der eingespeisten Energie zeigt sich, dass die vertikale Komponente der Lorentzkraft deutlich mehr steigt als die horizontale Komponente und die Änderung der Kraft vom Ort abhängt.

Werden alle Spulen mit verbreitertem Windungsquerschnitt 4b betrieben (Fig. 16), so erhöhen sich die Lorentzkraftdichten, die in der Schmelze wirken, gleichmäßig und die Richtungen der Kraftdichten ändern sich nicht. Wird nur der Windungsquerschnitt 4b der mittleren Spule 6 verbreitert, erhöhen sich die Kraftdichten in der Schmelze 2, die Richtungen der Kräfte ändern sich und die Verstärkung der Kraft ist nicht homogen. Die gezielte Verbreiterung des Windungsquerschnittes 4b einer oder mehrerer Spulen ermöglicht es, die Kraftfelder nicht nur zu verstärken - wie bei einer gleichmäßige Verbreiterung des Windungsquerschnittes 4b -; sie erlaubt es auch die Richtung der Kraft zu verändern.

Eine Verstärkung der horizontalen Kraftkomponente gegenüber der vertikalen Komponente wird also erreicht, indem in die mittlere Spule 6 eine höhere Leistung eingespeist wird als in den übrigen Spulen 5 und 7. Ein ähnlicher Effekt wird erreicht, wenn der Windungsquerschnitt 4b der mittleren Spule verbreitert wird und weiterhin in alle Spulen in etwa die gleiche Leistung eingespeist wird.

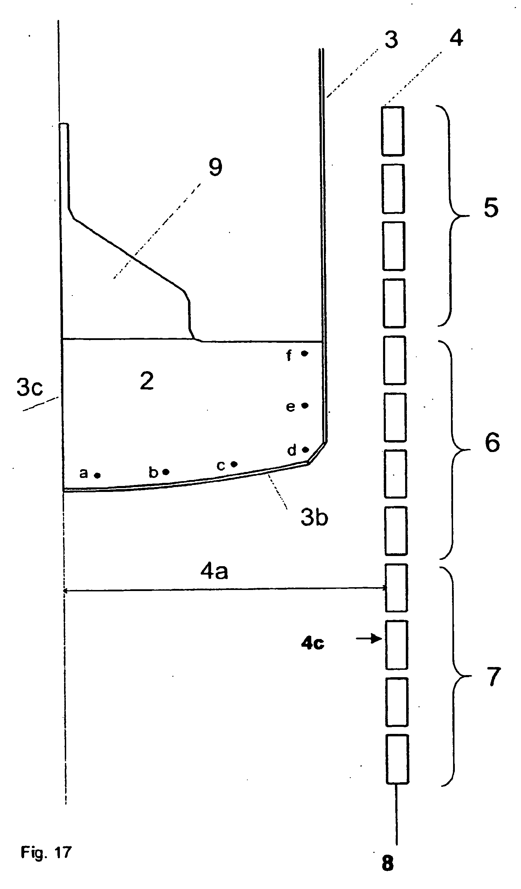

Es werden weitere Simulationsrechnungen mit Vorrichtungen nach den Fig. 17 bis 19 durchgeführt.

In einer zehnten Simulationsrechnung mit einer Vorrichtung nach Fig. 17 beträgt die Phasenverschiebung zwischen den Spulen 5 und 6 und zwischen den Spulen 6 und 7 jeweils 120°. In alle drei Spulen 5, 6, 7 wurden mit einer gleichen Stromstärke von jeweils 145 A und einer Frequenz von 50 Hz gespeist.

Es hat sich gezeigt, dass bei einer Heizeinrichtung nach Fig. 17 mit drei übereinander angeordneten Spulen 5, 6, 7 mit gleichem Abstand 4a von der gedachten Tiegelmittelachse 3c zum Innenrand 4c der Windungen 8 und gleichem Windungsquerschnitt 4b die Lorentzkraftdichte in der Schmelze 2 in Nähe der Tiegelwand 3a - Monitorpunkte d, e und f - wesentlich stärker ist, als am Tiegelboden 3b - Monitorpunkte a, b und c -. Die Lorentzkraftdichte in der Schmelze 2 nimmt hier von der Tiegelwand 3a zur gedachten Tiegelmittelachse 3c des Tiegels 3b um zwei Größenordnungen ab. Die berechneten Werte für die Anordnung nach Fig. 17 sind in der Tabelle 5 in der ersten Reihe dargestellt.

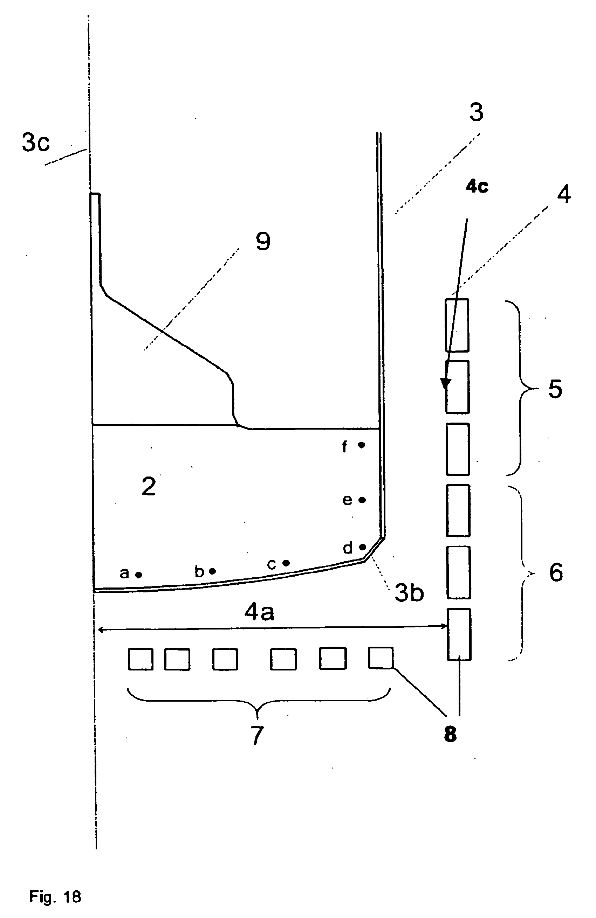

Bei einer weiteren elften Simulation mit einer Heizeranordnung nach Fig. 18 mit 2 übereinander angeordneten zylindrischen Spulen 5, 6 und einer dritten Spule 7 mit sich verringernden Abständen 4a der Windungen 8 zur gedachten Tiegelmittelachse 4c kann das Maximum der Lorentzkraftdichte an den Tiegelboden 3b in den Bereich des Monitorpunktes c verschoben werden. Bei dieser Simulation wurden alle Spulen 5, 6 und 7 mit einer Frequenz von 50 Hz und jeweils einer Phasenverschiebung von 120° zwischen den Spulen eingespeist. Zur Verstärkung der magnetischen Kraftwirkung am Tiegelboden 3b betrug die eingespeiste Stromstärke in der Spule 7 145 A und den Spulen 5 und 6 davon abweichend jeweils 30 A.

Die Ergebnisse sind der Tabelle 5 in der zweiten Wertereihe dargestellt. Es hat sich gezeigt, dass die thermisch bedingte Auftriebskonvektion im Bereich unterhalb des Kristalls 9 besonders stark reduzierbar ist.

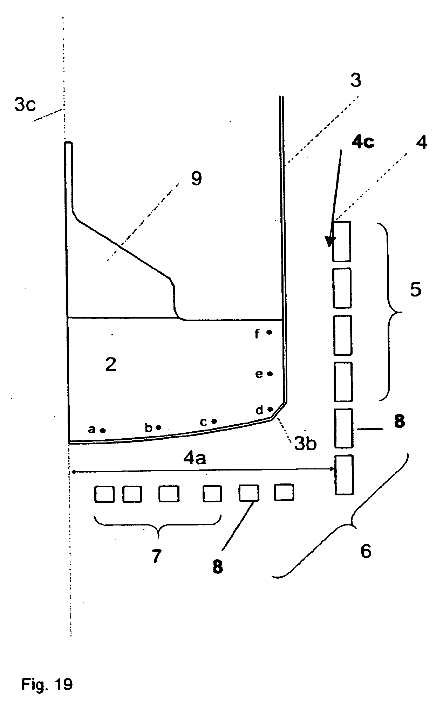

Eine weitere zwölfte Simulation zur Beeinflussung der Lorentzkraftdichte am Tiegelboden 3b wurde mit einer Vorrichtung nach Fig. 19 durchgeführt. Bei dieser Vorrichtung befindet sich eine zylindrische Spule 5 oberhalb einer Spule 6, die dadurch gekennzeichnet ist, dass sie zwei Windungen 8 mit identischen Abstand 4a von der gedachten Tiegelmittelachse 4c und zwei Windungen 8 mit reduziertem Abstand 4a aufweist. Die Spule 7 besitzt nur ineinanderliegende Windungen 8 mit unterschiedlichen Abstand 4a von der gedachten Tiegelmittelachse 4c. Bei dieser Anordnung wurden die drei Spulen wie folgt angesteuert: Die Frequenz beträgt 50 Hz und die eingespeiste Stromstärke 145 A in allen drei Spulen. Die Phasenverschiebung zwischen Spule 5 und 6 beträgt 10° und zwischen Spule 6 und 7 beträgt 70°.

Durch die Variation der Phasenverschiebung zwischen den Spulen 5, 6 und 7 ist auch eine Verschiebung des Maximums und der berechneten Lorentzkraftdichte zum Monitorpunkt c erreichbar. Die Simulationsergebnisse sind in der Tabelle 5 in der der dritten Messreihe zusammengestellt. Der Vorteil gegenüber einer Variation der Stromstärke besteht darin, dass die Temperaturverteilung aufgrund der eingespeisten Stromstärken nicht beeinflusst wird. Es erscheint auch eine Kombination der Variation von Stromstärke und Phasenverschiebung zwischen den Spulen als sinnvoll, um ein "maßgeschneidertes Lorentzkraftfeld" zu erzielen und gleichzeitig eine Kristallzüchtung aus der Schmelze zu gewährleisten.

In Tabelle 5 werden die Ergebnisse für die berechneten Lorentzkraftdichten an den Monitorpunkten a - f für die Simulationsrechnungen nach Vorrichtungen gemäß der Fig. 17 bis 19 zusammengefasst.

**Tabelle 5**

| Lorentzkraftdichten für Monitorpunkte in den Vorrichtungen | **a** [N/m³] | **b** [N/m³] | **c** [N/m³] | **d** [N/m³] | **e** [N/m³] | **f** [N/m³] |
|---|---|---|---|---|---|---|
| Fig.17 | **0,2** | **2** | **9** | **21** | **23** | **26** |
| Fig. 18 | **4** | **22** | **33** | **17** | **1** | **-5** |
| Fig. 19 | **6** | **33** | **54** | **45** | **22** | **1** |

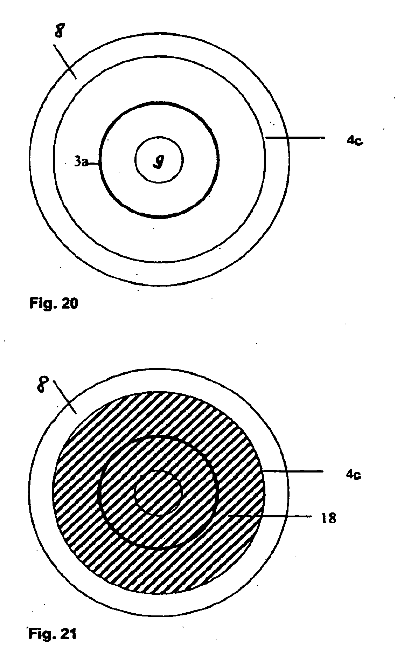

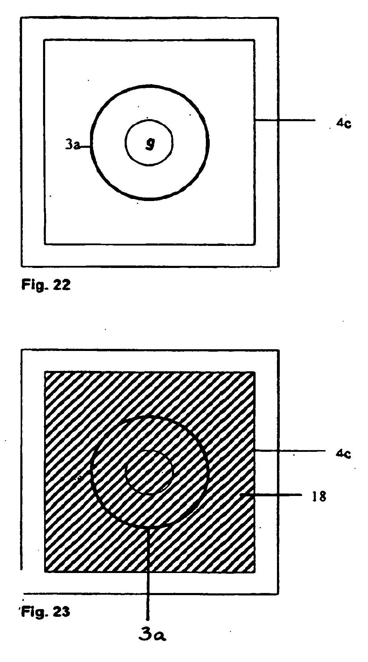

In Fig. 20 wird eine schematische Darstellung der Aufsicht auf eine Kristallzüchtungsanlage gezeigt. Fig. 21 stellt eine schematische Darstellung der Aufsicht auf eine Kristallzüchtungsanlage wie in Fig. 20 mit der Markierung einer von der Windung umschlossenen runden Fläche dar. Fig. 22 zeigt eine weitere schematische Darstellung der Aufsicht auf eine Kristallzüchtungsanlage und in Fig. 23 wird eine schematische Darstellung der Aufsicht auf eine Kristallzüchtungsanlage wie in Fig. 22 gezeigt, wobei hier die markierte von einer Windung umschlossenen Fläche quadratisch ist.

### Bezugszeichenliste

- 1 1: Züchtungskammer
- 2: Schmelze
- 3: Tiegel
- 3a: Tiegelwand
- 3b: Tiegelboden
- 3c: gedachte Tiegelmittelachse

- 4: Heizeinrichtung
- 4a: Abstand
- 4b: Windungsquerschnitt
- 4c: Innenrand
- 5: Spule
- 6: Spule
- 7: Spule
- 8: Windungen

- 9: Kristall

- 10: Spulenanschluss
- 11: Spulenanschluss
- 12: Spulenanschluss
- 13: Spulenanschluss
- 14: Energieversorgungseinrichtung

- 15: Spule
- 16: Spule
- 17: Tripelpunkt

- 18: von einer Windung umschlossene Fläche

- n: Anzahl der Windungen
- a: Monitorpunkt
- b: Monitorpunkt
- c: Monitorpunkt
- d: Monitorpunkt
- e: Monitorpunkt
- f: Monitorpunkt
- g: Monitorpunkt
- h: Monitorpunkt
- i: Monitorpunkt
- j: Monitorpunkt
- k: Monitorpunkt
- l: Monitorpunkt

## Patentansprüche

1. Vorrichtung zur Herstellung von Kristallen aus elektrisch leitenden Schmelzen, mindestens aufweisend einen in einer Züchtungskammer (1) angeordneten, eine Schmelze (2) enthaltenen Tiegel (3) mit einem Tiegelboden (3b), eine den Tiegel umgebende Heizeinrichtung (4), welche als Mehrspulenanordnung von über einander angeordneten Spulen (5), (6), (7) ausgeführt ist und zur gleichzeitigen Erzeugung eines magnetischen Wanderfeldes dient, wobei die Spulen elektrisch mit mindestens einer außerhalb der Züchtungskammer (1) angeordneten Energieversorgungseinrichtung (14) über durch die Züchtungskammer (1) geführte Spulenanschlüsse (10), (11), (12), (13) elektrisch verbunden sind, **dadurch gekennzeichnet, dass**
Windungen (8) der Mehrspulenanordnung einen Abstand (4a) von einer gedachten Tiegelmittelachse (3c) zum Innenrand (4c) der Windungen (8) aufweisen, der mindestens bei einer Windung (8) verschieden von den übrigen Windungen (8) bei gleichem oder verschiedenen Windungsquerschnitten (4b) ist.

2. Vorrichtung nach Anspruch 1, **dadurch gekennzeichnet, dass** mindestens eine weitere Spule (15), (16) unterhalb des Tiegelbodens (3b) des Tiegels (3) angeordnet ist.

3. Vorrichtung nach Anspruch 2, **dadurch gekennzeichnet, dass** die unterhalb des Tiegelbodens angeordneten Spulen (15), (16) Windungen (8) aufweisen, die ineinander angeordnet sind.

4. Vorrichtung nach einem der Ansprüche 1 bis 3, **dadurch gekennzeichnet, dass** die Windungen (8) mindestens einer Spule (5), (6), (7), (15), (16) einen von den übrigen Spulen (5), (6), (7), {15}, (16) abweichenden Abstand (4a) zu der gedachten Tiegelmittelachse (3c) aufweisen.

5. Vorrichtung nach einem der Ansprüche 1 bis 4, **dadurch gekennzeichnet, dass** die Windungen (8) mindestens einer Spule (5), (6), (7), (15), (16) einen von den übrigen Spulen (5), (7) abweichenden Windungsquerschnitt (4b) aufweisen.

6. Vorrichtung nach einem der Ansprüche 1 bis 5, **dadurch gekennzeichnet, dass** der Abstand (4a) mindestens einer Windung (8) von der gedachten Tiegelmittelachse (3c) zum Innenrand (4c) der Windung (8) gegenüber den der anderen Windungen (8) geringer ist.

7. Vorrichtung nach einem der Ansprüche 1 bis 6, **dadurch gekennzeichnet, dass** mindestens ein Windungsquerschnitt (4b) der Windungen innerhalb einer Spule (5), (6), (7), (15), (16) gegenüber den weiteren Windungen (8) der Spule (5), (6), (7), (15), (16) unterschiedlich ist.

8. Vorrichtung nach einem der Ansprüche 1 bis 7, **dadurch gekennzeichnet, dass** die Windungen (8) der Spulen (5), (6), (7), (15), (16) aus unterschiedlichen Materialien bestehen.

9. Vorrichtung nach einem der Ansprüche 1 bis 8, **dadurch gekennzeichnet, dass** die Spulen (5), (6), (7), (15), (16) eine unterschiedlichen Anzahl (n) von Windungen (8) aufweisen.

10. Vorrichtung nach einem der Ansprüche 1 bis 8, **dadurch gekennzeichnet, dass** die Spulen (5), (6), (7), (15), (16) eine gleiche Anzahl (n) von Windungen (8) aufweisen.

11. Vorrichtung nach einem der Ansprüche 1 bis 10, **dadurch gekennzeichnet, dass** der Windungsquerschnitt (4b) die Form einer beliebigen geometrischen Fläche aufweist.

12. Vorrichtung nach Anspruch 11, **dadurch gekennzeichnet, dass** der Windungsquerschnitt (4b) eine rechteckige, quadratische oder runde Form aufweist.

13. Vorrichtung nach einer der Ansprüche 1 bis 12, **dadurch gekennzeichnet, dass** eine von der Windung (8) umschlossene Fläche (18) die Form einer beliebigen geometrischen Fläche aufweist.

14. Verfahren zur Herstellung von Kristallen aus elektrisch leitenden Schmelzen mittels einer Vorrichtung nach mindestens einem der Ansprüche 1 bis 13, wobei in einer in einem Tiegel (3) enthaltene Schmelze (2) durch eine aus Spulen (5), (6), (7) aufgebaute Mehrspulenanordnung ein Lorentzkraftfeld mit einem im Bereich einer Tiegelwand (3a) aufweisenden Lorentzkraftdichtemaximum erzeugt wird,
**dadurch gekennzeichnet, dass** das Lorentzkraftdichtemaximum vom Bereich der Tiegelwand (3a) durch Steuerung der in die Spulen (5), (6), (7), (15), (16) eingespeisten Größen Stromstärke, Phasenverschiebung und Frequenz zu einer gedachten Tiegelmittelache (3c) hin verschoben wird.

15. Verfahren nach Anspruch 14, **dadurch gekennzeichnet, dass** in mindestens eine Spule (5), (6), (7), (15), (16) eine von den übrigen Spulen abweichende Phasenverschiebung eingespeist wird.

16. Verfahren nach Anspruch 14, **dadurch gekennzeichnet, dass** in den Spulen (5), (6), (7), (15), (16) die gleichen Phasenverschiebungen eingespeist werden.

17. Verfahren nach einem der Ansprüche 14 bis 16, **dadurch gekennzeichnet, dass** in mindestens eine Spule (5), (6), (7), (15), (16) eine von den übrigen Spulen abweichende Stromstärke eingespeist wird.

18. Verfahren nach einem der Ansprüche 14 bis 16, **dadurch gekennzeichnet, dass** in den Spulen (5), (6), (7), (15), (16) jeweils gleich große Stromstärken eingespeist werden.

19. Verfahren nach einem der Ansprüche 14 bis 18, **dadurch gekennzeichnet, dass** mindestens eine Spule (6) mit einer höheren Stromstärke gegenüber den übrigen Spulen (5), (7), (15), (16) betrieben wird.

20. Verfahren nach einem der Ansprüche 14 bis 18, **dadurch gekennzeichnet, dass** mindestens eine Spule (6) mit einer niedrigeren Stromstärke gegenüber den übrigen Spulen (5), (7), (15), (16) betrieben wird.

21. Verfahren nach einem der Ansprüche 14 bis 20, **dadurch gekennzeichnet, dass** in mindestens eine Spule (5), (6), (7), (15), (16) eine von den übrigen Spulen abweichende Frequenz eingespeist wird.

22. Verfahren nach einem der Ansprüche 14 bis 20, **dadurch gekennzeichnet, dass** in die Spulen (5), (6), (7), (15), (16) jeweils die gleiche Frequenz eingespeist wird.

23. Verfahren nach einem der Ansprüche 14 bis 22, **dadurch gekennzeichnet, dass** die Steuerung der Größen Phasenverschiebung, Stromstärke und Frequenz mit einer hohlzylindrischen Mehrspulenanordnung erfolgt.

## Claims

1. A device for producing crystals from electroconductive melts, comprising at least a crucible (3) that is arranged in a growth chamber (1) and contains a melt (2) and that includes a crucible base (3b), a heating device (4) surrounding the crucible and that is designed as a multiple coil arrangement of coils (5), (6), (7) placed on top of each other and serves to generate a travelling magnetic field at the same time, wherein the coils are electrically connected to at least one power supply device (14) arranged outside the growth chamber (1) by means of coil connectors(10), (11), (12), (13) passing through the growth chamber (1), **characterized in that** windings (8) of the multiple coil arrangement comprise a distance (4a) from an imaginary central axis (3c) of the crucible to the inner edge (4c) of the windings (8), wherein said distance in at least one winding (8) is different from the other windings (8) while the cross-sections (4b) of the windings (4b) are the same or different.

2. A device according to claim 1, **characterized in that** at least one further coil (15), (16) is arranged below the crucible base (3b) of the crucible (3).

3. A device according to claim 2, **characterized in that** the coils (15), (16) that are arranged below the crucible base comprise windings (8) that are arranged inside one another.

4. A device according to any one of claims 1 to 3, **characterized in that** the windings (8) of at least one coil {5}, (6), (7), (15), (16) comprise a distance (4a) from the imaginary central axis (3c) of the crucible which is different from the other coils (5), (6), (7), (15), (16).

5. A device according to any one of claims 1 to 4, **characterized in that** the windings (8) of at least one coil (5), (6), (7), (15), (18) comprise a cross-section (4b) of the windings which is different from the other coils (5), (7).

6. A device according to any one of claims 1 to 5, **characterized in that** the distance (4a) of at least one winding (8) from the imaginary central axis (3c) of the crucible to the inner edge (4c) of the winding (8) is smaller, compared to those of the other windings (8).

7. A device according to any one of claims 1 to 6, **characterized in that** at least one cross-section (4b) of the windings within a coil (5), (6), (7), (15), (16) is different, compared to the other windings (8) of the coil (5), (6), (7), (15), (16).

8. A device according to any one of claims 1 to 7, **characterized in that** the windings (8) of the coils (5), (6), (7), (15), (16) consist of different materials.

9. A device according to any one of claims 1 to 8, **characterized in that** the coils (5), (6), (7), (15), (16) comprise a different number (n) of windings (8).

10. A device according to any one of claims 1 to 8, **characterized in that** the coils (5), (6), (7), (15), (16) comprise an identical number (n) of windings (8).

11. A device according to any one of claims 1 to 10, **characterized in that** the cross-section (4b) of the windings is in the form of any plane geometric figure.

12. A device according to claim 11, **characterized in that** the cross-section (4b) of the windings has a rectangular, square or round shape.

13. A device according to any one of claims 1 to 12, **characterized in that** an area (18) enclosed by the winding (8) is in the form of any plane geometric figure.

14. A method for producing crystals from electroconductive melts by means of a device according to at least one of claims 1 to 13, wherein a Lorentz force field whose Lorentz force density maximum is located in the area of a crucible wall (3a) is generated in a melt (2) contained in a crucible (3) by means of a multiple coil arrangement that is made up of coils (5), (6), (7), **characterized in that** the Lorentz force density maximum can be displaced from the area of the crucible wall (3a) towards an imaginary central axis (3c) of the crucible by controlling the current, phase shift and frequency supplied to the coils (5), (6), (7), (15), (16).

15. A method according to claim 14, **characterized in that** at least one coil (5), (6), (7), (15), (16) is supplied with a phase shift that is different from the other coils.

16. A method according to claim 14, **characterized in that** the same phase shifts are supplied to the coils (5), (6), (7), (15), (16).

17. A method according to any one of claims 14 to 16, **characterized in that** at least one coil (5), (6), (7), (15), (16) is supplied with a current that is different from the other coils.

18. A method according to any one of claims 14 to 16, **characterized in that** the same currents are supplied to each of the coils (5), (6), (7), (15), (16).

19. A method according to any one of claims 14 to 18, **characterized in that** at least one coil (6) is operated at a higher current, compared to the other coils (5), (7), (15), (16).

20. A method according to any one of claims 14 to 18, **characterized in that** at least one coil (6) is operated at a lower current, compared to the other coils (5), (7), (15), (16).

21. A method according to any one of claims 14 to 20, **characterized in that** at least one coil (5), (6), (7), (15), (16) is supplied with a frequency that is different from the other coils.

22. A method according to any one of claims 14 to 20, **characterized in that** the same frequency is supplied to each of the coils (5), (6), (7), (15), (16).

23. A method according to any one of claims 14 to 22, **characterized in that** the phase shift, current and frequency are controlled by means of a multiple coil arrangement in the form of a hollow cylinder.

## Revendications

1. Dispositif de production de cristaux à partir de bains fondus électriquement conducteurs, présentant au moins un creuset (3), avec un fond de creuset (3b), disposé dans une chambre de culture (1), contenant un bain fondu (2), un équipement de chauffage (4), entourant le creuset, qui est réalisé en tant qu'agencement à bobines multiples de bobines (5), (6), (7) disposées les unes sur les autres, et qui sert simultanément à la production d'un champ d'ondes progressives magnétique, les bobines étant connectées électriquement, par le biais de connexions de bobines (10), (11), (12), (13) conduites à travers la chambre de culture (1), à au moins un équipement d'alimentation en énergie (14) disposé à l'extérieur de la chambre de culture (1), **caractérisé en ce que** des spires de l'agencement à bobines multiples présentent une distance (4a) depuis un axe de milieu de creuset (3c) imaginaire jusqu'au bord intérieur (4c) des spires (8) qui, au moins pour une spire (8), est différent des autres spires (8) pour des sections transversales de spires (4b) identiques ou différentes.

2. Dispositif selon la revendication 1, **caractérisé en ce qu'**au moins une autre bobine (15), (16) est disposée au-dessous du fond de creuset (3b) du creuset (3).

3. Dispositif selon la revendication 2, **caractérisé en ce que** les bobines (15), (16) disposées au-dessous du fond de creuset présentent des spires (8) qui sont disposées les unes dans les autres.

4. Dispositif selon une des revendications 1 à 3, **caractérisé en ce que** les spires (8) d'au moins une bobine (5), (6), (7), (15), (16) présentent une distance à l'axe de milieu de creuset (3c) imaginaire qui diverge des autres bobines (5), (6), (7), (15), (16).

5. Dispositif selon une des revendications 1 à 4, **caractérisé en ce que** les spires (8) d'au moins une bobine (5), (6), (7), (15), (16) présentent une section transversale de spire (4b) qui diverge des autres bobines (5), (7).

6. Dispositif selon une des revendications 1 à 5, **caractérisé en ce que** la distance (4a) d'au moins une spire (8) depuis l'axe de milieu de creuset (3c) imaginaire jusqu'au bord intérieur (4c) de la spire (8) est plus courte par rapport à celle des autres spires (8).

7. Dispositif selon une des revendications 1 à 6, **caractérisé en ce qu'**au moins une section transversale de spire (4b) des spires à l'intérieur d'une bobine (5), (6), (7), (15), (16) est différente par rapport aux autres spires (8) de la bobine (5), (6), (7), (15), (16).

8. Dispositif selon une des revendications 1 à 7, **caractérisé en ce que** les spires (8) des bobines (5), (6), (7), (15), (16) se composent de matériaux différents.

9. Dispositif selon une des revendications 1 à 8, **caractérisé en ce que** les bobines (5), (6), (7), (15), (16) présentent un nombre (n) de spires (8) différent.

10. Dispositif selon une des revendications 1 à 8, **caractérisé en ce que** les bobines (5), (6), (7), (15), (16) présentent un nombre (n) de spires (8) identique.

11. Dispositif selon une des revendications 1 à 10, **caractérisé en ce que** la section transversale de spire (4b) présente la forme d'une surface géométrique quelconque.

12. Dispositif selon la revendication 11, **caractérisé en ce que** la section transversale de spire (4b) présente une forme rectangulaire, carrée ou ronde.

13. Dispositif selon une des revendications 1 à 12, **caractérisé en ce qu'**une forme (18) enclose par la spire (8) présente la forme d'une surface géométrique quelconque.

14. Procédé de production de cristaux à partir de bains fondus électriquement conducteurs au moyen d'un dispositif selon au moins une des revendications 1 à 13, un champ de force de Lorentz avec un maximum de densité de force de Lorentz dans la zone d'une paroi de creuset (3a) étant produit dans un agencement à bobines multiples constitué par des bobines (5), (6), (7) dans un bain fondu (2) contenu dans un creuset (3), **caractérisé en ce que** le maximum de densité de force de Lorentz de la plage de la zone de la paroi de creuset (3a) est, sous l'action de la commande des grandeurs intensité de courant, déphasage et fréquence introduites dans les bobines (5), (6), (7), (15), (16), poussé vers un axe de milieu de creuset (3c) imaginaire.

15. Procédé selon la revendication 14, **caractérisé en ce qu'**un déphasage différent des autres bobines est introduit dans au moins une bobine (5), (6), (7), (15), (16).

16. Procédé selon la revendication 14, **caractérisé en ce que** les mêmes déphasages sont introduits dans les bobines (5), (6), (7), (15), (16).

17. Procédé selon une des revendications 14 à 16, **caractérisé en ce qu'**une intensité de courant différente des autres bobines est introduite dans au moins une bobine (5), (6), (7), (15), (16).

18. Procédé selon une des revendications 14 à 16, **caractérisé en ce que** des intensités de courant respectivement identiques sont introduites dans les bobines (5), (6), (7), (15), (16).

19. Procédé selon une des revendications 14 à 18, **caractérisé en ce qu'**au moins une bobine (6) est mise en oeuvre avec une intensité de courant plus élevée par rapport aux autres bobines (5), (6), (7), (15), (16).

20. Procédé selon une des revendications 14 à 18, **caractérisé en ce qu'**au moins une bobine (6) est mise en oeuvre avec une intensité de courant plus faible par rapport aux autres bobines (5), (6), (7), (15), (16).

21. Procédé selon une des revendications 14 à 20, **caractérisé en ce qu'**une fréquence différente des autres bobines est introduite dans au moins une bobine (5), (6), (7), (15), (16).

22. Procédé selon une des revendications 14 à 20, **caractérisé en ce que** respectivement la même fréquence est introduite dans les bobines (5), (6), (7), (15), (16).

23. Procédé selon une des revendications 14 à 22, **caractérisé en ce que** la commande des grandeurs intensité de courant, déphasage et fréquence s'effectue avec un agencement à bobines multiples cylindrique creux.
